Europäisches Patentamt

European Patent Office

Office européen des brevets

(19)

(11) Publication number: **0 372 126**
**A1**

# (12) EUROPEAN PATENT APPLICATION

(21) Application number: **88311305.2**

(22) Date of filing: **29.11.88**

(51) Int. Cl.⁵: **H01L 21/329, H01L 21/56**

(43) Date of publication of application:
**13.06.90 Bulletin 90/24**

(84) Designated Contracting States:
**AT BE CH DE ES FR GB GR IT LI LU NL SE**

(71) Applicant: **MITSUI PETROCHEMICAL INDUSTRIES, LTD.**
**2-5, Kasumigaseki 3-chome Chiyoda-ku Tokyo 100(JP)**

(72) Inventor: **Tamada, Masahiko**
**3-4 Misono 1-chome**
**Ootake-shi Hiroshima(JP)**

(74) Representative: **Myerscough, Philip Boyd et al**
**J.A.Kemp & Co. 14, South Square Gray's Inn**
**London, WC1R 5EU(GB)**

(54) Method for encapsulating electronic parts and encapsulated parts.

(57) Encapsulated electronic parts are disclosed, which are obtained by injection molding into an injection mold having inserted therein semiconductor chips mounted on a metallic lead frame a modified poly-4-methyl-1-pentene graft-modified with an unsatured carboxylic acid or its derivative, having a melt flow rate of at least 50 g/10 min.

Further disclosed are encapsulated electronic parts, which are obtained by injection molding into an injection mold having inserted therein semiconductor chips mounted on a metallic lead frame a modified or unmodified poly-4-methyl-1-pentene to encapsulate the semiconductor chip portion, and then injection molding a glass fiber-reinforced poly-4-methyl-1-pentene composition onto the external lead portion.

EP 0 372 126 A1

## METHOD FOR ENCAPSULATING ELECTRONIC PARTS AND ENCAPSULATED ELECTRONIC PARTS

### FIELD OF THE INVENTION

This invention relates to methods for encapsulating semiconductor chips, according to the insert injection molding technique, by the use of poly-4-methyl-1-pentene or modified poly-4-methyl-1-pentene and to electronic parts encapsulated with poly-4-methyl-1-pentene.

### BACKGROUND OF THE INVENTION

As a method for encapsulating electronic parts such as semiconductor chips, IC chips, etc. with resins, there is most widely adopted the so-called insulating encapsulating method wherein the electronic parts are insulated by encapsulation, according to the potting, sealing, transfer molding or the like molding technique, with thermosetting resins such as epoxy resins, urethane resins or silicone. In the above-mentioned insulation encapsulating method using these resins, however, there was such a serious problem that the process becomes poor in productivity as the resin used for encapsulating has to be adjusted, prior to the encapsulation step, to B-stage (precured state), a long curing time is necessary to bring out inherent characteristics of the encapsulating resin, and the encapsulated electronic parts obtained thereby are required to be postcured.

With the view of furnishing a solution of the above-mentioned problem, an attempt has been made to enhance the aforesaid productivity by injection molding thermoplastic resins directly into a mold having inserted electronic or electrical parts therein. In the resin encapsulation method involving injection molding of thermoplastic resins as mentioned above, however, there were such problems that because of a high temperature of at least 200°C and a high pressure of at least 300 kg/cm$^2$ usually required for the practice of injection molding of thermoplastic resins, the electronic or electrical parts to be encapsulated therewith are damaged, or when IC chips are encapsulated therewith, bonding wires thereof are broken. Further, there was another problem that because thermoplastic resins are generally poor in heat resistance in comparison with thermosetting resins, when semiconductor chips encapsulated with a thermoplastic resin are soldered, parts of the thermoplastic resin come to fuse by heat of a soldering iron or by heat transmitted from external leads.

### OBJECT OF THE INVENTION

With the intention of solving the above-mentioned problems associated with the prior art and of developing a method for encapsulating semiconductor chips with resins by the insert injection molding technique using thermoplastic resins and electronic parts encapsulated with the thermoplastic resins excellent in resistance to solder, the present inventor prosecuted extensive researches and eventually has accomplished the present invention on the basis of his finding that such problems as mentioned above are solved at once by virtue of using a specific poly-4-methyl-1-pentene as the thermoplastic resin for the purposes intended.

### SUMMARY OF THE INVENTION

The first method for encapsulating electronic parts of the present invention is characterized by injection molding into an injection mold having inserted therein semiconductor chips mounted on a metallic frame a modified poly-4-methyl-1-pentene graft-modified either partly or wholly with an unsaturated carboxylic acid or its derivative, said modified poly-4-methyl-1-pentene having a graft-modified amount of the unsaturated carboxylic acid or its derivative of 0.01-10% by weight and a melt flow rate of 50 g/10 min, thereby encapsulating said semiconductor chips.

Further, the second method for encapsulating electronic parts of the present invention is characterized by injection molding into an injection molding mold having inserted therein semiconductor chips mounted on a metallic frame a modified or unmodified poly-4-methyl-1-pentene having a melt flow rate of at least 50 g/10 min, encapsulating said semiconductor chips therewith, and then injection molding a glass fiber-reinforced poly-4-methyl-1-pentene composition onto the external lead portion of the encapsulated semiconductor chips.

Furthermore, the first electronic part of the present invention is characterized in that semiconductor chips mounted on a metallic frame are encapsulated with a modified poly-4-methyl-1-pentene, a part or whole of which has been graft-modified with an unsaturated carboxylic acid or its derivative.

Still further, the second electronic part of the present invention is characterized by comprising a semiconductor chip portion encapsulated with a modified or unmodified poly-4-methyl-1-pentene and an external lead portion encapsulated with a glass fiber-reinforced poly-4-methyl-1-pentene composition.

The electronic parts of the present invention as illustrated above are excellent in water resistance, heat resistance, transparency, resistance to soldering heat, chemical resistance and adhesive properties.

## DETAILED DESCRIPTION OF THE INVENTION

The methods for encapsulating electronic parts and encapsulated electronic parts of the present invention are illustrated below in detail.

According to the first method for encapsulating electronic parts of the present invention, semiconductor chips are encapsulated by injection molding technique with modified poly-4-methyl-1-pentenes which have been graft-modified, either partly or wholly, with an unsaturated carboxylic acid or its derivative, said modified poly-4-methyl-1-pentenes having a graft-modifying amount of said unsaturated carboxylic acid or its derivative of 0.01-10% by weight, preferably 0.5-5% by weight, and a melt flow rate (MFR; load 5 kg, temperature 260°C) of at least 50 g/10 min, preferably at least 60 g/10 min.

By poly-4-methyl-1-pentene as used herein, on which the modified poly-4-methyl-1-pentenes are based, is meant a homopolymer of 4-methyl-1-pentene or a copolymer of 4-methyl-1-pentene and other $\alpha$-olefin, for example, $\alpha$-olefin of 2-20 carbon atoms such as ethylene, propylene, 1-butene, 1-hexane, 1-octene, 1-decene, 1-tetradecene and 1-octadecene, which is a polymer consisting essentially of 4-methyl-1-pentene and usually containing at least 85 mol% of the 4-methyl-1-pentene. This poly-4-methyl-1-pentene is desirably crystalline.

The modified poly-4-methyl-1-pentenes used in the present invention are obtained by graft modifying such poly-4-methyl-1-pentenes as mentioned above with an unsaturated carboxylic acid or its derivative. The unsaturated carboxylic acid or its derivative used in that case include unsaturated carboxylic acids such as acrylic acid, maleic acid, fumaric acid, tetrahydrophthalic acid, itaconic acid, citraconic acid, crotonic acid, isocrotonic acid and nadic acid® (endocis-bicyclo[2,2,1]hepto-5-ene-2,3-dicarboxylic acid) or derivatives thereof, for example, acid halides, amides, imides, anhydrides and esters thereof, including concretely malenyl chloride, maleimide, maleic anhydride, citraconic anhydride, monomethyl maleate, dimethyl maleate, glycidyl maleate, etc. Of these compounds, unsaturated carboxylic acids or derivatives thereof are suitable for the purpose intended, particularly preferred are maleic acid, nadic acid® or acid anhydrides thereof.

In preparing the modified products as intended for use in the present invention by graft copolymerization of the above-mentioned poly-4-methyl-1-pentenes with a graft monomer selected from the aforesaid unsaturated carboxylic acids or derivatives thereof, various known methods are adoptable therefor. For instance, there may be mentioned a process which comprises carrying out graft copolymerization of a molten poly-4-methyl-1-pentene by the addition of a graft monomer thereto, or a method which involves graft copolymerization of a solution of poly-4-methyl-1-pentene in a solvent to be carried out by the addition of a graft monomer thereto. In either case, it is preferable to carry out the reaction in the presence of a radical initiator for the purpose of carrying out efficiently the graft copolymerization of the poly-4-methyl-1-pentene with the graft monomer. The graft reaction is carried out usually at a temperature of 60-350°C. The radical initiator is usually used in an amount of 0.001-1 part by weight based on 100 parts by weight of the poly-4-methyl-1-pentene used. The radical initiator used in this case include organic peroxides, organic peresters and azo compounds. Of these radical initiators, those which are preferably useful are dialkylperoxides such as dicumyl peroxide, di-tert-butyl peroxide, 2,5-dimethyl-2,5-di(tertbutylperoxy)hexine3, 2,5-dimethyl-2,5-di(tert-butyl)hexane, 1,4-bis(tert-butylperoxyisopropyl)benzene, etc.

In cases where the graft-modified amount of modified poly-4-methyl-1-pentene mentioned above is less than 0.01% by weight, there is a tendency that adhesive properties and moisture resistance between the metallic frame and the modified poly-4-methyl-1-pentene become poor. If, on the one hand, the graft-modified amount exceeds 10% by weight, the graft-modified poly-4-methyl-1-pentene becomes high in hydroscopicity and tends to become poor in moisture resistance and water resistance.

Further, if a melt flow rate of the modified poly-4-methyl-1-pentene is less than 50 g/10 min, semiconductor chips are liable to breakage or bonding wires (metallic fine wires) are liable to breakage and deformation at the time when said modified resin is injection molded into an injection mold. Though the upper limit of melt flow rate of the modified poly-4-methyl-1-pentene is not particularly limited, on the one hand, said upper limit is preferably less than about 200 g/10 min from the standpoint of mechanical strength of the encapsulated portion.

Furthermore, the modified poly-4-methyl-1-pentene preferably has its melting point (ASTM D 3418) in the range of from 200 to 240°C.

The modified poly-4-methyl-1-pentenes used in the present invention may be those in which the whole of poly-4-methyl-1-pentene has been graft-modified, or may be those in which a part of poly-4-methyl-1-pentene has been graft-modified. That is, in the present invention, there may be used also a composition comprising a modified poly-4-methyl-1-pentene and an unmodified poly-4-methyl-1-pentene. In that case, however, this composition must have the graft-modified amount of the poly-4-methyl-1-pentene and the melt flow rate as defined above. Accordingly, when the modified poly-4-methyl-1-pentene is used in admixture with the unmodified poly-4-methyl-1-pentene, this modified poly-4-methyl-1-pentene is not always necessary to have such graft-modified amount of poly-4-methyl-1-pentene and melt flow rate as defined previously in this case, and the graft-modified amount of the poly-4-methyl-1-pentene is usually less than 15% by weight, preferably less than 10% by weight.

The second method for encapsulating electronic parts of the present invention is illustrated hereinafter. In the second method, a modified poly-4-methyl-1-pentene or unmodified poly-4-methyl-1-pentene having a melt flow rate of at least 50 g/10 min is injection molded into an injection mold having inserted therein semiconductor chips mounted on a metallic frame to encapsulate said semiconductor chips, and then a glass fiber-reinforced poly-4-methyl-1-pentene composition is injection molded onto the external lead portion.

In the second method for encapsulating electronic parts of the present invention, the modified poly-4-methyl-1-pentene or unmodified poly-4-methyl-1-pentene used for encapsulating the electronic parts are the same as those used in the first method for encapsulating electronic parts of the present invention, that is, the modified poly-4-methyl-1-pentene of the unmodified poly-4-methyl-1-pentene on which said modified poly-4-methyl-1-pentene is based. Such modified or unmodified poly-4-methyl-1-pentene used in the second method for encapsulating electronic parts of the present invention desirably have a melt flow rate of at least 50 g/10 min, preferably at least 60 g/10 min.

In the second method for encapsulating electronic parts of the present invention, the external lead portion is encapsulated with a glass fiber-reinforced poly-4-methyl-1-pentene composition. The glass fiber-reinforced poly-4-methyl-1-pentene composition (hereinafter called FR-PMP) as used herein is intended to designate poly-4-methyl-1-pentene reinforced with glass fiber, which is a composition reinforced by the addition of glass fiber usually in an amount of 1-300 parts by weight, preferably 10-100 parts by weight based on 100 parts by weight of the poly-4-methyl-1-pentene. If the amount of glass fiber added is small, the resulting composition is not improved in resistance to soldering heat and, on the one hand, an excessively large amount of glass fiber added tends to mar the resulting composition in appearance.

Poly-4-methyl-1-pentene (B) constituting FR-PMP are polymers basically falling under the same category as of polymer-4-methyl-1-pentenes (A) used for encapsulating the above-mentioned conductor chip portion. Since the external lead portion is hard to break in composition with the semiconductor chip or internal lead (bonding wires, i.e. metallic fine wires) and the semiconductor chip portion surrounded by the external lead portion is covered with the above-mentioned poly-4-methyl-1-pentene, the glass fiber-reinforced poly-4-methyl-1-pentene covering the external lead portion does not directly come in touch with the semiconductor chip portion. For that reason, MFR of the poly-4-methyl-1-pentene incorporated with glass fiber and covering the external lead portion is usually 0.5-200 g/10 min, preferably 10-200 g/10 min.

Further, a part of whole of the poly-4-methyl-1-pentene (B) may be graft-modified with an unsaturated carboxylic acid or its derivative in order to improve adhesive properties between the poly-4-methyl-1-pentene and glass fiber and adhesive properties between said poly-4-methyl-1-pentene and the external lead portion.

The glass fiber (C) used in the present invention is a reinforcing material for thermoplstic resins, and has usually has a fiber diameter of 1-20 μm, preferably 6-12 μm, and a fiber length of 1-10 mm, preferably 3-6 mm.

4

Glass fiber constituting FR-PMP is not always surface treated, however, if the surface treated glass fiber is used, the resulting FR-PMP is further improved in heat deformation temperature and mechanical properties. Surface treated glass fiber generally includes those which have been subjected to surface treatment with silane type compounds having amino groups. The silane type compounds having amino groups may be those which easily react with unsaturated carboxylic acids or acid anhydrides thereof, for example, $\gamma$-aminopropyl trimethoxysilane, $\gamma$-aminopropyl triethoxysilane, N-($\beta$-aminoethyl)-$\gamma$-aminopropyl trimethoxysilane, etc.

The modified or unmodified poly-4-methyl-1-pentenes used in the present invention may be incorporated with heat stabilizers, weathering agents, lubricants, nucleating agents, pigments, dyes, mold lubricants, etc., in such a range where they do not hinder the objects of the present invention.

Further, FR-PMP used in the present invention may also be incorporated with heat stabilizers, weathering agents, lubricants, nucleating agents, flame retardants, flame-retardant assistants, inorganic fillers, potassium titanate fiber, mold lubricants, carbon fiber, etc., in such a range where they do not hinder the objects of the present invention.

A melt flow rate of FR-PMP is usually 0.1-200 g/10 min, preferably 1-100 g/10 min.

The semiconductor chips used in the present invention include, for example, elements of luminescent diode (LED), IC chips, etc.

In the present invention, such modified or unmodified poly-4-methyl-1-pentenes as mentioned above are injection molded into an injection mold having inserted therein semiconductor chips mounted on a metallic frame.

The molding conditions under which the modified or unmodified poly-4-methyl-1-pentenes are injected into the mold are not particularly limited, however, usually the molding temperature (cylinder temperature of injection molding machine) is 250-350°C, preferably 260-320°C, the injection molding speed is more than 1 g/sec, preferably 1 g/sec to 8 g/sec, the mold temperature is 10° to 80°C, preferably 20° to 60°C, and the injection pressure is 5 kg/cm².G to 70 kg/cm² .G, preferably 15 kg/cm² .G to 50 kg/cm².G.

The molding conditions under which FR-PMP is injected into the mold are not particularly limited, however, usually the molding temperature (cylinder temperature of injection molding machine) is 250°-330°C, preferably 260°-300°C, the injection molding speed is 1.0 g/sec to 10 g/sec, preferably 1 g/sec to 8 g/sec., the mold temperature is 10°-80°C, preferably 20°-60°C, and the injection pressure is 10 kg/cm².G to 70 kg/cm².G, preferably 15 kg/cm².G to 50 kg/cm².G.

In the second method for encapsulating electronic parts of the present invention, the first step of encapsulating the semiconductor chip portion with the modified or unmodified poly-4-methyl-1-pentene and the second step of encapsulating the external lead portion with FR-PMP may be carried out continuously in that order in the same injection mold by using two injection molding machines, or may be carried out separately in such a manner that an intermediate molded article obtained by encapsulating the semiconductor chip portion in the first step using one injection mold and one injection molding machine is taken out therefrom and the intermediate molded article is then inserted into the other injection mold wherein the external lead portion is encapsulated with FR-PMP by using the other injection molding machine.

In the second method for encapsulating electronic parts of the present invention, it is desirable that the semiconductor chip portion is perfectly covered with the modified or unmodified poly-4-methyl-1-pentenes and, on the one hand, the external lead portion is not always covered entirely with FR-PMP, but from the standpoint of improved solder resistance, the whole of the external lead portion is encapsulated with FR-PMP.

The first encapsulated electronic part of the present invention comprises semiconductor chips mounted on a metallic frame and encapsulated with the modified poly-4-methyl-1-pentene which has been graft-modified, either partly or wholly, with an unsaturated carboxylic acid or its derivative.

The second encapsulated electronic part of the present invention comprises the semiconductor chip portion encapsulated with the poly-4-methyl-1-pentene and the external lead portion encapsulated with RF-PMP.

Such electronic parts of the present invention as illustrated above include, for example, luminescent diodes, visible luminescent diode, infrared luminescent diodes, etc.

According to the methods of encapsulating electronic parts of the present invention, it is possible to encapsulate the electronic parts with poly-4-methyl-1-pentenes without breaking or cutting semiconductor chips, bonding wires, etc., and hence the encapsulation methods of the present invention are markedly excellent in productivity as compared with the conventional encapsulation methods using thermosetting resins such as epoxy resins. Further, the encapsulated electronic parts of the present invention are excellent in electrical insulation properties, water resistance, moisture resistance, heat resistance, resistance to soldering heat, transparency and chemical resistance. Particularly, the luminescent diodes having the structure in accordance with the present invention are excellent in transparency, and the luminescent diodes having used, either partly or wholly, in the encapsulated semiconductor portion the poly-4-methyl-1-pentene graft-modified with a saturated carboxylic acid or its derivative have such features that they are excellent in moisture resistance, water resistance, heat cycle properties and adhesive properties.

The present invention is illustrated below in detail with reference to examples, but it should be construed that the invention is in no way limited to those examples.

## Example 1

Luminescent diode chips mounted on a metallic lead frame were placed in an injection mold, and the luminescent diode chip portion was encapsulated with a 4-methyl-1-pentene/1-decene copolymer having a MFR of 80 g/10 min and the 1-decene content of 3.0% by weight. The injection molding machine used was an injection molding machine M-1000 manufactured and sold by Meiki Seisakusho K.K., and the injection molding conditions employed were such that the resin temperature was 310°C, injection pressure was 20 kg/cm2.G, injection molding speed was 2 g/sec, and mold temperature was 40°C.

The lead frame having thus mounted thereon the luminescent diode chip portion encapsulated in the manner as mentioned above was placed in an injection mold. Subsequently, the external lead portion was encapsulated by means of the above-mentioned injection molding machine using a composition (MFR: 100 g/10 min) obtained by mixing together 100 parts by weight of a 4-methyl-1-pentene/1-decene copolymer having MFR of 26 g/10 min and the 1-decene content of 3.0% by weight, 30 parts by weight of glass fiber (a product of Asahi Fiber Glass K.K. sold under a trade name of GR-S-3A; fiber diameter 13μm) and 5 parts by weight of a modified poly-4-methyl-1-pentene having 4.0% by weight of maleic anhydride as grafted, intrinsic viscosity $[\eta]$ of 0.95 dl/g, melting point of 210°C and crystallinity index of 18% by means of a Henschel mixer, followed by melt kneading with a 40 mm ø extruder (preset at 260°C). The injection molding conditions employed were such that the resin temperature was 290°C, injection molding pressure was 35 kg/cm2.G, injection speed was 3 g/sec and mold temperature was 40°C.

The luminescent diode (I) thus obtained exhibited a function as luminescent diode, showing no cut of the metallic fine wires.

The following tests were conducted to evaluate adhesive properties between the luminescent diode (I) obtained and the lead frame, and solder resistance of said diode.

## Adhesion test:

The luminescent diode immersed in a red ink solution was boiled for 1 hour, and the diode pulled up from the red ink solution was then washed to visually evaluate penetration of red ink into the diode portion.

(Ratings)

o : No penetration of the red ink was observed.
Δ : Red ink penetrated into the encapsulated body of the diode up to 1 mm from the base thereof.
x : Red ink penetrated into the encapsulated diode portion up to the part near the semiconductor chips.

## Solder resistance test:

In a solder bath kit at 260°C, the encapsulated luminescent diode was immersed up to 2 mm from the base of the body of the diode, and the immersed diode was pulled up from the bath to visually evaluate the appearance thereof.
(Refer to JIS C7021 A-1)

(Ratings)

o : No change in appearance of the immersed portion was observed.
Δ : The immersed portion somewhat fused.
x : The immersed portion fused, and the lead frame moved off or the resin foamed.

The results obtained are shown in Table 1.

## Example 2

A modified 4-methyl-1-pentene copolymer (MAH-MD-I) having a MFR of 80 g/10 min and 0.8% by weight of maleic anhydride as grafted was obtained by mixing together 100 parts by weight of a 4-methyl-1-pentene/1-decene copolymer having an MFR of 0.5 g/10 min and the 1-decene content of 3.0% by weight, 1.0 part by weight of maleic anhydride and 0.05 part by weight of 2,5-dimethyl-2,5-di(tert-butylperoxy)-hexine-3 by means of a Henschel mixer, followed by melt kneading with a 40 mm ⌀ extruder (preset at 260°C).

An encapsulated luminescent diode was prepared by repeating Example 1 except that in place of the 4-methyl-1-pentene/1-decene copolymer used therein, there was used MAH-MD-I obtained above.

The encapsulated luminescent diode (II) showed favorable appearance thereof with no cut of gold wires and no damage of the semiconductor chip portion.

Evaluation of adhesive properties and solder resistance was conducted in the same manner as in Example 1.

The results obtained are shown in Table 1.

## Comparative Example 1

A semiconductor chip portion and gold fine wires of luminescent diode and the whole of the external lead portion were encapsulated in an injection mold with a 4-methyl-1-pentene/1-decene copolymer having a MFR of 150 g/10 min and the 1-decene content of 3.0% by weight. The injection molding conditions employed were such that the resin temperature was 300°C, injection pressure was 15 kg/cm². G, injection speed was 3 g/sec, mold temperature was 40°C and the injection molding machine was the same as that used in Example 1.

The encapsulated luminescent diode had a good appearance without any cut of the gold fine wires. The encapsulated diode (III) thus obtained was evaluated with respect to adhesive properties and solder resistance in the same manner as in Example 1.

The results obtained are shown in Table 1.

## Comparative Example 2

An encapsulated luminescent diode (IV) was prepared by using polycarbonate having a MFR of 35 g/10 min (load 2.16 kg, temperature 260°C) and the same injection molding machine as in Comparative Example 1 under the molding conditions involving the molding temperature of 310°C, injection pressure of 20 kg/cm². G, injection speed of 3 g/sec and mold temperature of 90°C.

The encapsulated diode was evaluated with respect to adhesive properties and solder resistance in the same manner as in Example 1.

The results obtained are shown in Table 1.

Table 1

| Example | Test item | |
|---|---|---|
| | Adhesive property | Solder resistance |
| Example 1 | ○ | ○ |
| Example 2 | ○ | ○ |
| Comparative Example 1 | △ | △ |
| Comparative Example 2 | x | x |

Example 3

Into an injection mold was placed a lead frame having mounted thereon luminescent diode chips, and MHA-MD-I obtained in Example 2 was injection molded into the mold by means of the same injection molding machine as used in Example 1 to encapsulate the semiconductor chip portion and the external lead portion under the injection molding conditions of molding temperature: 310° C, injection pressure: 15 kg/cm$^2$.G, injection speed: 2 g/sec, and mold temperature: 40° C, whereby an encapsulated luminescent diode was prepared.

The encapsulated luminescent diode (V) thus obtained had a favorable appearance without any damage of semiconductor chips and without any cut of the gold fine wires.

Evaluation of adhesive properties was conducted in the same manner as in Example 1.

The results obtained are shown in Table 2.

Further, the encapsulated luminescent diode was tested for moisture resistance by the following procedure.

Moisture resistance test:

The encapsulated luminescent diode was allowed to stand at 60° C and RH 90% for 20 days and then subjected to the same adhesion test as in Example 1 to visually evaluate penetration of red ink. The same ratings were adopted.

The results obtained are shown in Table 2.

Example 4

With MAH-MD-I obtained in Example 2 were first encapsulated the semiconductor chip portion and external lead portion of luminescent diode by means of the same injection molding machine as used in Example 1 under the conditions of molding temperature: 310° C, injection pressure: 10 kg/cm$^2$.G, injection speed: 2 g/sec, and mold temperature: 40° C. Thereafter, the encapsulated semiconductor chip and external lead portions were further encapsulated with a 4-methyl-1-pentene/1-decene copolymer having an MFR of 70 g/10 min and the 1-decene content of 3.0% by weight, whereby an encapsulated luminescent diode (VI) having the specified dimensions was obtained.

The encapsulated luminescent diode thus obtained exhibited its function as a luminescent diode, without showing no cut of the wires. Further, evaluation of adhesive properties and moisture resistance was conducted in the same manner as in Examples 1 and 3.

The results obtained are shown in Table 2.

Example 5

A mixture comprising 100 parts by weight of a 4-methyl-1-pentene/1-decene copolymer having a MFR of 0.5 g/10 min and the 1-decene content of 3.0% by weight, 10 parts by weight of maleic anhydride and 0.05 part by weight of 2,5-dimethyl-2,5-di(tert-butylperoxy)hexine-3 was mixed with a Henschel mixer and then melt kneaded with a 40 mm ø extruder (preset at 260° C) to obtain a modified 4-methyl-1-pentene copolymer (MAH-MD-II) having an MFR of 80 g/10 min and 9.5% by weight of maleic anhydride as grafted.

Subsequently, 70 parts by weight of a 4-methyl-1-pentene/1-decene copolymer having a MFR of 70 g/10 min and the 1-decene content of 3.0% by weight and 30 parts by weight of the modified poly-4-methyl-1-pentene copolymer (MAH-MD-II) were mixed together with a Henschel mixer. Using the copolymer thus obtained, an encapsulated luminescent diode (VII) was prepared in the same manner as in Example 3.

The encapsulated luminescent diode thus obtained exhibited its function as a luminescent diode, showing no cut of the wires.

Further, evaluation of adhesive properties and moisture resistance was conducted in the same manner as in Examples 1 and 3.

The results obtained are shown in Table 2.

Comparative Example 3

With a 4-methyl-1-pentene/1-decene copolymer having a MFR of 70 g/10 min, the conductor chip, wire and lead frame portions of a luminescent diode were encapsulated under the same molding conditions as in Example I to prepare an encapsulated luminescent diode (VIII). The encapsulated luminescent diode thus obtained was evaluated in the same manner as in Examples 1 and 3.

The results obtained are shown in Table 2.

Comparative Example 4

Using the same injection molding machine as used in Comparative Example 1, polycarbonate having a MFR of 35 g/10 min (load 2.16 kg, temperature 260°C) was injection molded under the conditions of molding temperature: 310°C, injection pressure: 20 kg/cm².G, injection speed: 2 g/sec, and mold temperature: 90°C to prepare an encapsulated luminescent diode (IX). The encapsulated luminescent diode was evaluated in the same manner as in Examples 1 and 3.

The results obtained are shown in Table 2.

Table 2

| Example | Test item | |
|---|---|---|
| | Adhesion test | Moisture resistance test |
| Example 3 | ○ | ○ |
| Example 4 | ○ | ○ |
| Example 5 | ○ | ○ |
| Comparative Example 3 | Δ | Δ |
| Comparative Example 4 | x | x |

## Claims

1. A method for encapsulating electronic parts, characterized by injection molding into an injection mold having inserted therein semiconductor chips mounted on a metallic lead frame a modified poly-4-methyl-1-pentene graft-modified either partly or wholly with an unsaturated carboxylic acid or its derivative, said modified poly-4-methyl-1-pentene having a grafted amount of the unsaturated carboxylic acid or its derivative of 0.01-10% by weight and a melt flow rate of at least 50 g/10 min, thereby encapsulating said semiconductor chips.

2. The method as claimed in claim 1 wherein the modified poly-4-methyl-1-pentene is a modified product of a copolymer of 4-methyl-1-pentene and ethylene, propylene, 1-butene, 1-hexene, 1-octene, 1-decene, 1-tetradecene or 1-octadecene.

3. A method for encapsulating electronic parts, characterized by injection molding into an injection mold having inserted therein semiconductor chips mounted on a metallic lead frame a modified or unmodified poly-4-methyl-1-pentene having a melt flow rate of at least 50 g/10 min, encapsulating said semiconductor chips therewith, and then injection molding a glass fiber-reinforced poly-4-methyl-1-pentene composition onto the external lead portion of the encapsulated semiconductor chip portion.

4. The method as claimed in claim 3 wherein the poly-4-methyl-1-pentene is a copolymer of 4-methyl-1-pentene and ethylene, propylene, 1-butene, 1-hexene, 1-octene, 1-decene, 1-tetradecene or 1-octadecene.

5. The method as claimed in claim 3 wherein the glass fiber-reinforced poly-4-methyl-1-pentene contains the glass fiber in an amount of 1-300 parts by weight based on 100 parts by weight of the poly-4-methyl-1-pentene.

6. A resin encapsulated electronic part, characterized in that semiconductor chips mounted on a metallic lead frame are encapsulated with a modified poly-4-methyl-1-pentene, a part or whole of which has been graft-modified with an unsaturated carboxylic acid or its derivative.

7. An encapsulated electronic part, characterized by comprising a semiconductor chip portion encapsulated with poly-4-methyl-1-pentene having a melt flow rate of at least 50 g/10 min and an external lead portion encapsulated with a glass fiber-reinforced poly-4-methyl-1-pentene composition.

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | PATENT ABSTRACTS OF JAPAN, vol. 12, no. 389 (E-669)[3236], 17th October 1988; & JP-A-63 131 529 (MITSUI PETROCHEM. IND. LTD) 03-06-1988 | 1,6,7 | H 01 L 21/329<br>H 01 L 21/56 |
| A | PATENT ABSTRACTS OF JAPAN, vol. 12, no. 455 [C-548], 29th November 1988; & JP-A-63 178 175 (MITSUI PETROCHEM. IND. LTD) 22-07-1988 | 1,2,6 | |
| A | PATENT ABSTRACTS OF JAPAN, vol. 12, no. 110 [C-486], 8th April 1988; & JP-A-62 236 851 (MITSUI PETROCHEM. IND. LTD) 16-10-1987 | 1-7 | |
| A | PATENT ABSTRACTS OF JAPAN, vol. 10, no. 23 [C-325], 29th January 1986; & JP-A-60 177 051 (MITSUI SEKIYU KAGAKU KOGYO K.K.) 11-09-1985 | 1-7 | |

TECHNICAL FIELDS SEARCHED (Int. Cl.5)

H 01 L

The present search report has been drawn up for all claims

| Place of search | Date of completion of the search | Examiner |
|---|---|---|
| THE HAGUE | 09-07-1989 | VANCRAEYNEST F.H. |